# EUROPEAN PATENT APPLICATION

(11) **EP 4 779 064 A1**
(43) Date of publication of application: **22.07.2026**
(21) Application number: 24865421.2
(22) Date of filing: 10.09.2024
(51) Int. Cl.: C30B 29/16, C23C 16/40

(54) **LAMINATE, SEMICONDUCTOR DEVICE USING SAME, AND METHOD FOR PRODUCING LAMINATE**

(30) Priority: 11.09.2023 JP 2023146942
(71) Applicant: SHIN-ETSU CHEMICAL CO., LTD., Tokyo 100-0005 (JP); Kochi Prefectural Public University Corporation, Kochi-shi, Kochi 780-8515 (JP)
(72) Inventor: YASUOKA,Tatsuya, Kami-shi, Kochi 782-8502 (JP); HASHIGAMI, Hiroshi, Annaka-shi, Gunma 379-0195 (JP); KAWAHARAMURA,Toshiyuki, Kami-shi, Kochi 782-8502 (JP); WATABE, Takenori, Annaka-shi, Gunma 379-0195 (JP); SAKATSUME, Takahiro, Annaka-shi, Gunma 379-0195 (JP); LIU, Li, Kami-shi, Kochi 782-8502 (JP); SUSAMI, Hiromu, Kami-shi, Kochi 782-8502 (JP); KOMATSU, Masahiko, Kami-shi, Kochi 782-8502 (JP)
(74) Representative: Schicker, Silvia
(86) International application number: PCT/JP2024/032302
(87) International publication number: WO 2025/057921

(57) **Abstract**

The present invention provides a laminate including a crystalline substrate, a first crystalline layer formed on a main surface of the crystalline substrate either directly or with another layer interposed therebetween, the first crystalline layer being composed primarily of a first crystalline metal oxide semiconductor, and a second crystalline layer formed on the first crystalline layer either directly or with another layer interposed therebetween, the second crystalline layer being composed primarily of a second crystalline metal oxide semiconductor, in which the second crystalline metal oxide semiconductor has the same composition as the first crystalline metal oxide semiconductor, and has a different crystalline phase from the first crystalline metal oxide semiconductor. Accordingly, it is possible to provide a laminate containing a crystalline metal oxide semiconductor with excellent physical properties that enable the manufacture of a high-performance semiconductor device, and a method for easily, inexpensively, and stably manufacturing such a laminate.

## Description

### TECHNICAL FIELD

The present invention relates to a laminate and a semiconductor device using the same, and a method for manufacturing the laminate.

### BACKGROUND ART

A film deposition method that uses fine water particles, such as mist CVD, is known as a method capable of forming a crystalline thin film at a low temperature and under atmospheric pressure. Such a method is drawing attention as it can particularly form a gallium oxide thin film having a metastable phase that is suitable for power semiconductor devices. Nowadays, the development of an ε (or κ) phase that is applicable to high-frequency devices has been actively pursued. In such a context, numerous studies have been conducted on crystals to form an underlayer of a gallium oxide layer. For example, Non Patent Document 1 discloses an example in which ε-GaFeO₃ is used. In addition, Patent Document 1 discloses an example in which α-(AlₓGa₁₋ₓ)₂O₃ formed on a c-plane sapphire substrate is used.

### CITATION LIST

### PATENT LITERATURE

Patent Document 1: JP 2019-46984 A

### NON PATENT LITERATURE

Non Patent Document 1: ACS Omega 2020, 5, 29585-29592

### SUMMARY OF INVENTION

### TECHNICAL PROBLEM

However, the foregoing conventional methods have the problem of high production costs due to the use of an expensive substrate or a complex process. Furthermore, since the electrical conductivity of the underlayer is difficult to control, the design flexibility of devices is reduced, which in turn hinders the achievement of high performance.

The present invention has been made to solve the foregoing problems, and an object of the present invention is to provide a low-cost laminate containing a crystalline metal oxide semiconductor with excellent physical properties that enable the manufacture of a high-performance semiconductor device, and a method for easily, inexpensively, and stably manufacturing such a laminate.

### SOLUTION TO PROBLEM

The present invention has been made to achieve the foregoing object, and provides a laminate comprising: a crystalline substrate; a first crystalline layer formed on a main surface of the crystalline substrate either directly or with another layer interposed therebetween, the first crystalline layer being composed primarily of a first crystalline metal oxide semiconductor; and a second crystalline layer formed on the first crystalline layer either directly or with another layer interposed therebetween, the second crystalline layer being composed primarily of a second crystalline metal oxide semiconductor, in which the second crystalline metal oxide semiconductor has the same composition as the first crystalline metal oxide semiconductor, and has a different crystalline phase from the first crystalline metal oxide semiconductor.

According to such a laminate, it is possible to obtain a laminate containing a crystalline metal oxide semiconductor with excellent physical properties that enable the manufacture of a high-performance semiconductor device.

At this time, each of the first crystalline metal oxide semiconductor and the second crystalline metal oxide semiconductor may be gallium oxide.

Accordingly, a laminate containing a crystalline metal oxide semiconductor with superior physical properties is obtained.

At this time, the first crystalline metal oxide semiconductor may be α-gallium oxide.

Accordingly, a laminate containing a crystalline metal oxide semiconductor with even superior physical properties is obtained.

At this time, the second crystalline metal oxide semiconductor may be ε-gallium oxide or κ-gallium oxide.

Accordingly, a laminate that is even more useful for semiconductor devices is obtained.

At this time, electric resistivity of the first crystalline layer may be 5 Ωcm or less.

Accordingly, a laminate that can implement a semiconductor device with superior characteristics is obtained.

At this time, the second crystalline layer may have higher electric resistivity than the first crystalline layer.

Accordingly, a laminate that can implement a semiconductor device with even superior characteristics is obtained.

At this time, the laminate may comprise an intermediate layer as the other layer provided between the first crystalline layer and the second crystalline layer.

Accordingly, a laminate with a higher-quality second crystalline layer is obtained.

At this time, the crystalline substrate may be a sapphire substrate.

Accordingly, a laminate that is less expensive and is suitable for application to semiconductor devices is obtained.

At this time, it is possible to provide a semiconductor device comprising at least a semiconductor layer and an electrode, in which the semiconductor layer includes the first crystalline layer and the second crystalline layer of the foregoing laminate.

Accordingly, a semiconductor device with excellent electrical characteristics is obtained.

The present invention also provides a method for manufacturing a laminate containing a crystalline metal oxide semiconductor, comprising the steps of: heating a crystalline substrate; forming a first gas mixture by mixing a raw material solution mist containing an atomized metal oxide precursor with a carrier gas; forming a first crystalline layer by supplying the first gas mixture to the crystalline substrate, the first crystalline layer being composed primarily of a first crystalline metal oxide semiconductor; modifying a surface of the first crystalline layer by exposing the surface to a surface modification atmosphere; and forming a second crystalline layer by supplying the first gas mixture to the crystalline substrate having the first crystalline layer with the modified surface, the second crystalline layer being composed primarily of a second crystalline metal oxide semiconductor having the same composition as the first crystalline metal oxide semiconductor and having a different crystalline phase from the first crystalline metal oxide semiconductor.

According to such a method for manufacturing a laminate, it is possible to easily and inexpensively manufacture a laminate with excellent physical properties suitable for semiconductor devices.

At this time, each of the first crystalline metal oxide semiconductor and the second crystalline metal oxide semiconductor may be gallium oxide.

Accordingly, it is possible to easily and inexpensively manufacture a laminate containing a crystalline metal oxide semiconductor with superior physical properties.

At this time, the surface modification atmosphere may be an atmosphere containing one of nitrogen, carbon dioxide, oxygen, ozone, and water vapor.

Accordingly, it is possible to easily and inexpensively manufacture a laminate with excellent physical properties that enable the manufacture of a high-performance semiconductor device.

At this time, a substrate temperature in the step of modifying the surface of the first crystalline layer may be set lower than or equal to a substrate temperature in the step of forming the first crystalline layer.

Accordingly, a high-quality laminate can be manufactured more stably.

In such a case, the substrate temperature in the step of modifying the surface of the first crystalline layer may be set to 20 °C or higher and 500°C or lower.

Accordingly, a high-quality laminate can be manufactured even more stably.

At this time, the step of forming the first crystalline layer may include further supplying a second gas mixture to the crystalline substrate, the second gas mixture being formed by mixing a supporting agent mist containing an atomized acidic solution with a carrier gas.

Accordingly, it is possible to reduce crystal defects in the first crystalline layer, and also improve the quality of the second crystalline layer formed thereon. Thus, a higher-quality laminate can be manufactured.

At this time, the step of forming the second crystalline layer may include further supplying a second gas mixture to the crystalline substrate, the second gas mixture being formed by mixing a supporting agent mist containing an atomized acidic solution with a carrier gas.

Accordingly, a laminate including a higher-quality second crystalline layer can be manufactured.

At this time, each of the step of forming the first crystalline layer and the step of forming the second crystalline layer may include further supplying a second gas mixture to the crystalline substrate, the second gas mixture being formed by mixing a supporting agent mist containing an atomized acidic solution with a carrier gas.

Accordingly, a laminate including even higher-quality first and second crystalline layers can be manufactured.

At this time, the acidic solution may contain hydrochloric acid.

Accordingly, it is possible to less expensively and stably manufacture a high-quality laminate.

### ADVANTAGEOUS EFFECTS OF INVENTION

As described above, according to the laminate of the present invention, it is possible to provide a low-cost laminate containing a crystalline metal oxide semiconductor with excellent physical properties that enable the manufacture of a high-performance semiconductor device. In addition, according to the method for manufacturing a laminate of the present invention, it is possible to easily, inexpensively, and stably manufacture a high-quality semiconductor laminate that enables the manufacture of a high-performance semiconductor device.

### BRIEF DESCRIPTION OF DRAWINGS

[FIG. 1] is a diagram illustrating an embodiment of a laminate containing a crystalline metal oxide semiconductor according to the present invention;
[FIG. 2] is a diagram illustrating another embodiment of a laminate containing a crystalline metal oxide semiconductor according to the present invention;
[FIG. 3] is a diagram illustrating further another embodiment of a laminate containing a crystalline metal oxide semiconductor according to the present invention;
[FIG. 4] is a diagram illustrating an embodiment of a method for manufacturing a laminate containing a crystalline metal oxide semiconductor according to the present invention; and
[FIG. 5] is a diagram illustrating an example of a high-electron-mobility transistor according to the present invention.

### DESCRIPTION OF EMBODIMENTS

Hereinafter, the present invention will be described in detail, but the present invention is not limited thereto.

As described above, there have been needs for a laminate containing a crystalline metal oxide semiconductor with excellent physical properties that enable the manufacture of a high-performance semiconductor device, and a method for easily, inexpensively, and stably manufacturing such a laminate.

The inventors have conducted extensive studies to solve the foregoing problems, and completed the present invention by finding that it is possible to obtain a laminate containing a crystalline metal oxide semiconductor with excellent physical properties that enable the manufacture of a high-performance semiconductor device, with a laminate including a crystalline substrate, a first crystalline layer formed on a main surface of the crystalline substrate either directly or with another layer interposed therebetween, the first crystalline layer being composed primarily of a first crystalline metal oxide semiconductor, and a second crystalline layer formed on the first crystalline layer either directly or with another layer interposed therebetween, the second crystalline layer being composed primarily of a second crystalline metal oxide semiconductor, in which the second crystalline metal oxide semiconductor has the same composition as the first crystalline metal oxide semiconductor, and has a different crystalline phase from the first crystalline metal oxide semiconductor.

The inventors have also completed the present invention by finding that it is possible to easily, inexpensively, and stably manufacture the foregoing laminate by using a method for manufacturing a laminate containing a crystalline metal oxide semiconductor, including the steps of: heating a crystalline substrate, forming a first gas mixture by mixing a raw material solution mist containing an atomized metal oxide precursor with a carrier gas, forming a first crystalline layer by supplying the first gas mixture to the crystalline substrate, the first crystalline layer being composed primarily of a first crystalline metal oxide semiconductor, modifying a surface of the first crystalline layer by exposing the surface to a surface modification atmosphere, and forming a second crystalline layer by supplying the first gas mixture to the crystalline substrate having the first crystalline layer with the modified surface, the second crystalline layer being composed primarily of a second crystalline metal oxide semiconductor having the same composition as the first crystalline metal oxide semiconductor and having a different crystalline phase from the first crystalline metal oxide semiconductor.

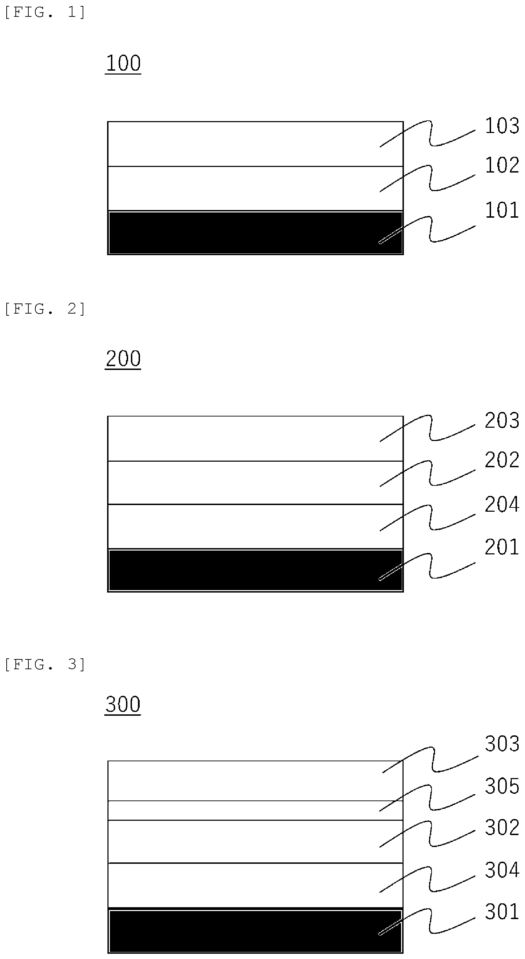

Hereinafter, the present invention will be described in detail with reference to FIGS. 1, 2, and 3, but the present invention is not limited thereto.

FIG. 1 illustrates an embodiment of a laminate containing a crystalline metal oxide semiconductor of the present invention (hereinafter sometimes referred to simply as a "laminate"). As illustrated in FIG. 1, a laminate 100 containing a crystalline metal oxide semiconductor basically includes a crystalline substrate 101, a first crystalline layer 102, and a second crystalline layer 103.

FIG. 2 illustrates another embodiment of a laminate containing a crystalline metal oxide semiconductor of the present invention. As illustrated in FIG. 2, a laminate 200 containing a crystalline metal oxide semiconductor basically includes a crystalline substrate 201, a first crystalline layer 202, and a second crystalline layer 203, and also includes a buffer layer 204 between the crystalline substrate 201 and the first crystalline layer 202.

FIG. 3 illustrates further another embodiment of a laminate containing a crystalline metal oxide semiconductor of the present invention. As illustrated in FIG. 3, a laminate 300 containing a crystalline metal oxide semiconductor basically includes a crystalline substrate 301, a first crystalline layer 302, and a second crystalline layer 303, and also includes a buffer layer 304 between the crystalline substrate 301 and the first crystalline layer 302, and an intermediate layer 305 between the first crystalline layer 302 and the second crystalline layer 303.

### [Substrate]

Each of the crystalline substrates 101, 201, and 301 is not limited to a particular substrate as long as it is a substrate composed primarily of a crystalline material, and may be any known substrate. The shape of the substrate is not limited to a particular shape, and may be any of circular, elliptical, and polygonal shapes. The substrate may be a conductive substrate, a semiconductor substrate, a single-crystalline substrate, or a polycrystalline substrate. For example, the substrate is preferably a high-quality, less expensive sapphire substrate.

Examples of the sapphire substrate include a c-plane sapphire substrate, an m-plane sapphire substrate, an a-plane sapphire substrate, and an r-plane sapphire substrate. In addition, the sapphire substrate may have an off-angle. The off-angle is not limited to a particular value, but is preferably 0° to 15°. Note that the thickness of the crystalline substrate is not limited to a particular value, but is preferably about 200 to 800 µm from a cost perspective.

### [First crystalline layer]

Each of the first crystalline layers 102, 202, and 302 is composed primarily of crystalline metal oxide. Such crystalline metal oxide may include the crystal structure of each of the crystalline substrates 101, 201, and 301. More preferably, it has the same crystal structure as each of the crystalline substrates 101, 201, and 301, and has a single orientation.

The crystalline metal oxide may be either the same as or different from the main component of each of the crystalline substrates 101, 201, and 301.

In addition, the crystalline metal oxide may be a single metal oxide or mixed crystals containing multiple metal elements. Specifically, the crystalline metal oxide may be oxide containing one of aluminum, titanium, vanadium, chromium, iron, gallium, rhodium, indium, and iridium.

The crystal structure of each of the first crystalline layers 102, 202, and 302 is not limited to a particular structure, and various crystal structures may be adopted, but in the present invention, corundum crystals are preferably used. Specific examples include Al₂O₃, Ti₂O₃, V₂O₃, Cr₂O₃, Fe₂O₃, Ga₂O₃, Rh₂O₃, In₂O₃, and Ir₂O₃. The crystalline metal oxide may be a binary metal oxide represented by (AₓB₁₋ₓ)₂O₃ (0 ≤ x ≤ 1), where two elements of the foregoing metal elements are represented by A and B, or a ternary metal oxide represented by (AₓB_{y}C_{1-x-y})₂O₃ (0 ≤ x ≤ 1 and 0 ≤ y ≤ 1), where three elements of the foregoing metal elements are represented by A, B, and C. Since such metal oxide can have a corundum structure, each of the first crystalline layers 102, 202, and 302 may have a corundum structure.

The foregoing crystalline metal oxide is preferably gallium oxide (Ga₂O₃), and more preferably, α-Ga₂O₃. Accordingly, a laminate containing a crystalline metal oxide semiconductor with superior physical properties is obtained. Note that α-Ga₂O₃ has a crystalline phase that exhibits a peak at least at around 2θ = 40.3° in an X-ray diffraction measurement.

Note that in the present invention, the phrase "be composed primarily of" or "main component" means that the crystalline metal oxide is present in a higher atomic proportion than any other components of all the components of the crystalline layer, and the proportion is preferably 50% or more, and may even be 100%. The proportion can be quantified using a known method such as secondary ion mass spectrometry or X-ray fluorescence analysis.

The thickness of each of the first crystalline layers 102, 202, and 302 is determined appropriately based on the design of the intended semiconductor device, but the lower limit can be set to 1 nm.

Although FIG. 1 illustrates an embodiment where the first crystalline layer 102 is formed directly on the crystalline substrate 101, the present invention is not limited thereto. The first crystalline layer 102 may be formed on the crystalline substrate 101 with another layer interposed therebetween. For example, to avoid the formation of defects due to crystal lattice mismatch between the crystalline substrate and the first crystalline layer, the first crystalline layer 202 may be formed via the buffer layer 204, as illustrated in FIG. 2.

In such a case, it is preferable that the lattice constant of the buffer layer 204 change continuously or stepwise along the growth direction of the buffer layer 204, from a value close to or about equal to the lattice constant of the substrate 201 to a value close to or about equal to the lattice constant of the first crystalline layer 202. For example, when an α-Ga₂O₃ crystalline region is formed on an Al₂O₃ substrate, the buffer layer is preferably formed of (AlₓGa₁₋ₓ)₂O₃ (0 ≤ x ≤ 1), with the value of x decreasing from the substrate 201 side toward the first crystalline layer 202 side. Alternatively, the buffer layer may be a superlattice structure film in which films of different compositions are alternately stacked.

The buffer layer 204 may be a sacrificial layer for peeling off the laminate from the substrate. In such a case, the buffer layer 204 may have different optical properties from the first crystalline layer 202, low mechanical brittleness, or solubility in a specific chemical solution, for example.

Each of the first crystalline layers 102, 202, and 302 may have conductivity. In such a case, each of the first crystalline layers 102, 202, and 302 may be doped with impurities for imparting conductivity. For example, when each of the first crystalline layers 102, 202, and 302 contains at least gallium, the impurities may be n-type dopants, such as silicon, germanium, tin, magnesium, titanium, zirconium, vanadium, or niobium; or p-type dopants, such as iron, copper, silver, cobalt, iridium, rhodium, magnesium, or nickel. The electric resistivity imparted to each of the first crystalline layers 102, 202, and 302 through impurity doping differs depending on the design of the intended semiconductor device, but is preferably set to 5 Ω·cm or less, and more preferably, 1 Ωcm or less for a high-electron-mobility transistor described later, for example. The lower limit is not limited to a particular value, but may be set to 0.01 Qcm. Accordingly, a laminate capable of implementing a semiconductor device with superior characteristics is obtained.

### [Second crystalline layer]

A crystalline metal oxide semiconductor that is a main component of each of the second crystalline layers 103, 203, and 303 has the same composition as, but a different crystalline phase from, a crystalline metal oxide semiconductor that is a main component of each of the first crystalline layers 102, 202, and 302. According to such a laminate, it is possible to obtain a laminate containing a crystalline metal oxide semiconductor with excellent physical properties that enable the manufacture of a high-performance semiconductor device.

The crystalline metal oxide semiconductor, which is the main component of each of the second crystalline layers 103, 203, and 303, is preferably gallium oxide. When the crystalline metal oxide semiconductor, which is the main component of each of the first crystalline layers 102, 202, and 302, is α-Ga₂O₃, the crystalline metal oxide semiconductor, which is the main component of each of the second crystalline layers 103, 203, and 303, is preferably β-Ga₂O₃ or ε (or κ)-Ga₂O₃. In the present invention, ε (or κ)-Ga₂O₃ is more preferable. Accordingly, a laminate containing a crystalline metal oxide semiconductor with superior physical properties is obtained.

Note that the ε phase and the κ phase are not clearly distinguished at present due to their structural similarity. Herein, each of the ε phase and the κ phase refers to a crystalline phase that exhibits a peak at least at around 2θ = 38.9° in an X-ray diffraction measurement.

Each of the second crystalline layers 103, 203, and 303 may be partially amorphous, or may be partially or entirely polycrystalline. However, it is preferable that each of the second crystalline layers 103, 203, and 303 be a single-orientation film in which all crystals are oriented along a single crystal axis, or single crystals.

Described above is an embodiment where the second crystalline layers 103 and 203 are formed directly on the first crystalline layers 102 and 202, respectively. However, the present invention is not limited thereto. As illustrated in FIG. 3, the second crystalline layer 303 may be formed on the first crystalline layer 302 with another layer (i.e., the intermediate layer 305) interposed therebetween.

The intermediate layer 305 may be a crystalline or amorphous layer containing the elements of the first crystalline layer 302, or a layer having a mixture of the crystalline and amorphous structures. In addition, the intermediate layer 305 may be a layer containing an element that terminates the surface of the first crystalline layer 302. Specifically, the intermediate layer 305 preferably contains one of hydrogen, oxygen, carbon, nitrogen, chlorine, bromine, and iodine, and may include one atomic layer or more than one atomic layer.

It is considered that forming such an intermediate layer 305 can prevent the propagation of dislocation defects in the first crystalline layer 302, thereby improving the quality of the second crystalline layer 303. Note that dislocation defects and their density can be evaluated using a known method such as TEM or the etch-pit method.

In addition, each of the second crystalline layers 103, 203, and 303 may have conductivity. In such a case, each of the second crystalline layers 103, 203, and 303 may be doped with impurities for imparting conductivity. When each of the second crystalline layers 103, 203, and 303 contains gallium oxide, the impurities may be n-type dopants, such as silicon, germanium, tin, magnesium, titanium, zirconium, vanadium, or niobium; or p-type dopants, such as iron, copper, silver, cobalt, iridium, rhodium, magnesium, or nickel.

The electric resistivity imparted to each of the second crystalline layers 103, 203, and 303 through impurity doping differs depending on the design of the intended semiconductor device, but is preferably higher than the electric resistivity imparted to the first crystalline layer, for example, 5 Ω·cm or more, and more preferably, 10 Ωcm or more for a high-electron-mobility transistor described later, for example. Accordingly, a laminate capable of implementing a semiconductor device with even superior characteristics is obtained.

The electrical resistance or the carrier density of the individual film and the laminate can be evaluated using a known method such as the four-probe method, the spreading resistance method, the eddy current method, scanning capacitance microscopy, or scanning microwave microscopy.

### [Semiconductor device including laminate of the present invention]

The laminate containing a crystalline metal oxide semiconductor of the present invention has excellent electrical characteristics, and is industrially useful. Such a laminate containing a crystalline metal oxide semiconductor is useful for semiconductor devices, particularly power devices.

In the semiconductor device of the present invention, a film of the crystalline metal oxide semiconductor may be as formed, or may be a film peeled off from a substrate or the like using a known method.

When such a detached film is used, the film may be transferred onto a support substrate, for example, for use. In such a case, the detached film and the support substrate may be fixed together using a known bonding technology, such as by using an adhesive or a tackifier, or by performing bonding via surfaces activated through plasma treatment.

The support substrate is not limited to a particular substrate as long as it can support the detached film without any problem during processes following the bonding. For example, substrates made of ceramic, glass, metals, semiconductors, or resin can be widely used.

The types of the laminate containing a crystalline metal oxide semiconductor of the present invention can be classified into lateral elements (i.e., lateral devices), where electrodes are formed on one side of the semiconductor layers, and vertical elements (i.e., vertical devices), where electrodes are formed on the front and back sides, respectively, of the semiconductor layers. The present invention is suitable for application to both lateral and vertical devices, but is particularly suitable for application to lateral devices. Specifically, the present invention is applied to high-electron-mobility transistors (HEMTs), for example.

Hereinafter, a preferred example in which each semiconductor film containing crystalline metal oxide of the present invention is applied to an n-type semiconductor layer (e.g., an n⁺-type semiconductor layer or an n⁻-type semiconductor layer) will be described with reference to the drawings. However, the present invention is not limited thereto. Note that the semiconductor device exemplarily illustrated below may further include other layers (e.g., insulating layers, semi-insulating layers, conductive layers, semiconductor layers, or other intermediate layers), and the buffer layer may be omitted as appropriate.

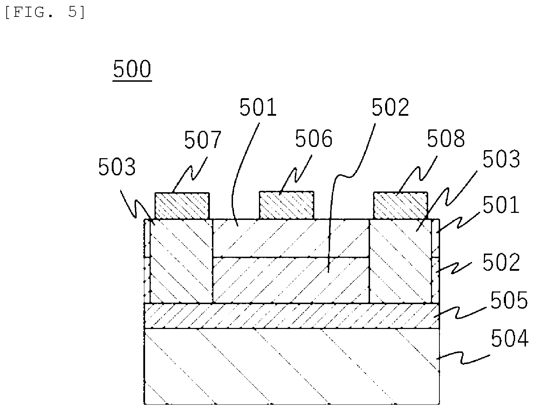

FIG. 5 illustrates an example of an HEMT to which the laminate containing a crystalline metal oxide semiconductor according to the present invention is applied. An HEMT 500 includes a wide bandgap n-type semiconductor layer (i.e., an electron injection layer) 501, a narrow bandgap n-type semiconductor layer (i.e., an electron transport layer) 502, an n⁺-type semiconductor layer 503, a support substrate 504, a buffer layer 505, a gate electrode 506, a source electrode 507, and a drain electrode 508.

The wide bandgap n-type semiconductor layer (i.e., the electron injection layer) 501 corresponds to the first crystalline layer of the present invention, and the narrow bandgap n-type semiconductor layer (i.e., the electron transport layer) 502 corresponds to the second crystalline layer of the present invention. In such a case, the narrow bandgap n-type semiconductor layer (i.e., the electron transport layer) 502 preferably has two-dimensional electron gas formed therein. To this end, it is preferable that the resistivity of the narrow bandgap n-type semiconductor layer (i.e., the electron transport layer) 502 be higher than at least the resistivity of the wide bandgap n-type semiconductor layer (i.e., the electron injection layer) 501.

Examples of materials for each electrode include metals, such as aluminum, molybdenum, cobalt, zirconium, tin, niobium, iron, chromium, tantalum, titanium, gold, platinum, vanadium, manganese, nickel, copper, hafnium, tungsten, iridium, zinc, indium, palladium, neodymium, and Ag, or alloys thereof; metal oxide conductive films, such as tin oxide, zinc oxide, rhenium oxide, indium oxide, indium tin oxide (ITO), and indium zinc oxide (IZO); organic conductive compounds, such as polyaniline, polythiophene, and polypyrrole; and a mixture thereof.

A method for depositing each electrode is not limited to a particular method. For example, each electrode is formed above the substrate according to a method appropriately selected from among wet methods, such as printing, spraying, and coating; physical methods, such as vacuum deposition, sputtering, and ion plating; and chemical methods, such as CVD and plasma CVD, considering the compatibility with the foregoing materials.

As described above, a semiconductor device, which includes the first and second crystalline layers of the laminate containing a crystalline metal oxide semiconductor of the present invention, is a semiconductor device with excellent electrical characteristics.

### [Method for manufacturing laminate]

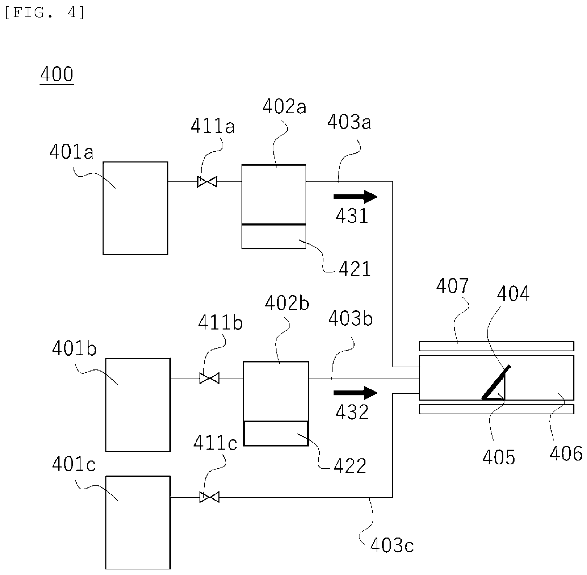

Hereinafter, an example of a method for manufacturing the laminate (i.e., the embodiment illustrated in FIG. 1) of the present invention will be described with reference to FIG. 4. However, the present invention is not limited thereto.

In the method for manufacturing the laminate of the present invention, a mist CVD apparatus 400 is basically used.

### [Step of heating crystalline substrate]

A crystalline substrate 404 is heated in a film deposition chamber 406 by a heat source 407. The temperature of the crystalline substrate 404 is appropriately optimized based on the raw materials used and the desired product to be formed. For example, to form α-Ga₂O₃, which is one of metastable phase crystals, as the first crystalline layer, the temperature of the crystalline substrate 404 is typically preferably set to 300°C to 600°C. At temperatures of 300°C or higher, the crystalline region is expected to be larger than the amorphous region, and at temperatures equal to or below 600°C, the metastable phase can be maintained more stably.

### [Step of forming first gas mixture]

A raw material solution 421 to be deposited is turned into a mist in an atomizer 402a. The type of the raw material solution 421 is not limited to a particular type as long as it can be turned into a mist. For example, a solution or a dispersion of a metal present as a complex or a salt in an organic solvent or water can be used.

Such a metal may be any metal capable of forming a semiconductor. Examples of such a metal include aluminum, titanium, vanadium, chromium, iron, gallium, rhodium, indium, and iridium. The content of the metal in the raw material solution is not limited to a particular value, but is preferably 0.001 mol/L to 50 mol/L, and more preferably, 0.01 mol/L to 5 mol/L.

Examples of salt forms include halide salts such as metal chloride salts, metal bromide salts, and metal iodide salts. In addition, the foregoing metal may also be used as a salt solution obtained by dissolving the metal in hydrogen halides such as hydrochloric acid, hydrobromic acid, or hydroiodic acid.

Examples of complex forms include acetylacetonate complexes, carbonyl complexes, ammine complexes, and hydride complexes. In addition, the acetylacetonate complexes can be formed by mixing acetylacetone with the foregoing salt solution.

It is preferable to use gallium oxide as the crystalline metal oxide semiconductor that is the main component of each of the first and second crystalline layers. Accordingly, it is possible to easily manufacture a laminate containing a crystalline metal oxide semiconductor with superior physical properties.

The raw material of impurities used for doping to impart conductivity to at least a part of the first crystalline layer is not limited to a particular material. For example, when the foregoing metal contains at least gallium, the impurities may be n-type dopants, such as silicon, germanium, tin, magnesium, titanium, zirconium, vanadium, or niobium; or p-type dopants, such as iron, copper, silver, cobalt, iridium, rhodium, magnesium, or nickel. Such compounds are preferably mixed into the raw material solution in an amount of 0.001 to 10 atomic percent, and more preferably, 0.01 to 1 atomic percent.

The solvent for the raw material solution 421 is not limited to a particular solvent. It may be an inorganic solvent, such as water, an organic solvent, such as alcohol, or a mixed solvent of inorganic and organic solvents. In the present invention, the solvent is preferably water.

Next, a valve 411a is opened to mix a carrier gas sent from a carrier gas source 401a with the mist in the atomizer 402a, thereby forming a first gas mixture 431. The type of the carrier gas is not limited to a particular type. For example, air, oxygen, or ozone, as well as an inert gas, such as nitrogen or argon, or a reducing gas, such as hydrogen gas or a forming gas, are suitably used. One type of carrier gas may be used, or two or more types of carrier gas may be used. The flow rate of the carrier gas varies depending on the substrate size and the size of the film deposition chamber, but is typically set to about 0.01 to 40 L/min.

In addition, though not illustrated, a gas similar to the carrier gas may be supplied as a diluent gas to the downstream side of the atomizer 402a, for example. The diluent gas used may be either the same as or different from the carrier gas. In such a case, the flow rate of the diluent gas varies depending on the film deposition conditions, but it is typically preferably set to 0.1 to 10 times that of the carrier gas per minute.

### [Step of forming first crystalline layer]

Next, the first gas mixture 431 is conveyed into the film deposition chamber 406 through a pipe 403a. The first gas mixture 431 introduced into the film deposition chamber 406 reacts with the crystalline substrate 404 heated in the film deposition chamber 406 by the heat source 407, thereby forming a film (i.e., the first crystalline layer) on the crystalline substrate 404.

The shape and the material of the film deposition chamber 406 are not limited to particular ones. For example, metals, such as aluminum and stainless steel, may be used. Alternatively, quartz or silicon carbide may be used if film deposition is performed at higher temperatures exceeding the heatproof temperature of such metals. Note that reference numeral 405 denotes a susceptor.

Film deposition may be performed under any of the following conditions: under atmospheric pressure, under pressure, and under reduced pressure. However, from the perspective of apparatus costs and productivity, film deposition is preferably performed under atmospheric pressure. Note that the film thickness can be appropriately set by adjusting the film deposition time.

In this step, a supporting agent mist obtained by atomizing an acidic solution may be mixed with the raw material solution mist, and supplied to the crystalline substrate 404 placed in the film deposition chamber 406 through a pipe 403b. In such a case, an atomizer 402b may be filled with an acidic solution 422, and a mist obtained by atomizing the acidic solution 422 may be mixed with a carrier gas sent from a carrier gas source 401b to form a second gas mixture 432, and then, the second gas mixture 432 may be supplied into the film deposition chamber together with the first gas mixture 431.

As the acidic solution 422, it is possible to use hydrochloric acid, hydrobromic acid, hydroiodic acid, sulfuric acid, nitric acid, hydrofluoric acid, an ammonium fluoride aqueous solution, a hydrogen peroxide solution, carboxylic acid, or a mixture thereof. However, from the perspective of production costs and process stability, the acidic solution 422 preferably contains hydrochloric acid. Using hydrochloric acid allows for less expensive, stable manufacture of a high-quality laminate.

The type of the solvent for the acidic solution 422 is not limited to a particular type. It may be an inorganic solvent, such as water, an organic solvent, such as alcohol, or a mixed solvent of inorganic and organic solvents. In the present invention, the solvent is preferably water. The acid concentration at this time is appropriately determined according to the film deposition conditions, but can be typically set to 0.01 mol/L to 2 mol/L.

The type of the carrier gas mixed with the second gas mixture 432 is not limited to a particular type. For example, air, oxygen, or ozone, as well as an inert gas, such as nitrogen or argon, or a reducing gas, such as a hydrogen gas or a forming gas, is suitably used. The carrier gas used herein may be either the same as or different from the carrier gas mixed with the first gas mixture 431. In addition, the flow rate of the second gas mixture 432 may be appropriately adjusted according to the desired film and its film deposition conditions, but it is typically preferably set to 2 to 50 times (in terms of the molar ratio) that of the metal element in the first gas mixture.

Such a supporting agent has the effect of suppressing the generation and growth (i.e., abnormal growth) of crystals of crystalline phases different from the desired crystals on the surface of the growing film, or stabilizing the growth of crystals of the desired crystalline phase. This allows for the stable formation of a high-quality first crystalline layer.

In addition, although the first gas mixture 431 and the second gas mixture 432 are independently supplied into the film deposition chamber 406 in the embodiment illustrated in FIG. 4, the present invention is not limited thereto. For example, the first gas mixture 431 and the second gas mixture 432 may be mixed together on the upstream side of the film deposition chamber 406 before being supplied into the film deposition chamber 406. In such a case, though not illustrated, a mist can be supplied into the film deposition chamber via a mist mixing vessel for mixing and agitating the first gas mixture and the second gas mixture, for example.

After a predetermined time has elapsed from the start of supply of the first gas mixture 431, the supply of the first gas mixture 431 is stopped to halt the film deposition. The method for stopping the supply of the first gas mixture 431 is not limited to a particular method. For example, the supply of the first gas mixture 431 may be stopped simply by stopping the atomization of the raw material, by closing the valve 411a while continuing the atomization of the raw material to stop the supply of the carrier gas from the carrier gas source 401a, or by performing both stopping the atomization of the raw material and closing the valve 411a.

### [Step of modifying surface]

Next, a valve 411c is opened to supply a surface modification gas sent from a surface modification gas source 401c to the crystalline substrate 404, which is placed in the film deposition chamber 406, through a pipe 403c. Thus, the surface of the first crystalline layer is held in the atmosphere of the surface modification gas so that a process of modifying the surface of the first crystalline layer is performed.

The surface modification gas preferably contains at least one of nitrogen, carbon dioxide, oxygen, ozone, and water vapor, and may even be atmospheric air. Accordingly, it is possible to easily manufacture a laminate with excellent physical properties that enable the manufacture of a high-performance semiconductor device.

This step may be performed while the crystalline substrate 404 is placed in the film deposition chamber, or the process may be performed by transferring the crystalline substrate 404 to a separate container (not illustrated) or, particularly when atmospheric air is used as the surface modification gas, to an open atmosphere.

When surface treatment is performed by placing the crystalline substrate 404 in a container, the container may be sealed after the interior of the container is replaced with the surface modification gas, or the surface modification gas may be continuously or intermittently flowed into the container. At this time, it is acceptable as long as the surface of the first crystalline layer is sufficiently exposed to the atmosphere of the surface modification gas. Therefore, the flow rate of the surface modification gas may be appropriately determined based on the volume of the container or space for performing the surface modification process and the substrate size, for example. However, particularly when the surface modification process is performed in a container, the flow rate of the surface modification gas is preferably set to about 2 to 10 times the volume of the container per minute.

In addition, the temperature of the crystalline substrate 404 at this time is typically preferably set to less than or equal to the substrate temperature during the formation of the first crystalline layer, and more preferably, 20°C to 500°C. Exposing the crystalline substrate 404 to the atmosphere of the surface modification gas at such temperatures allows molecules derived from the surface modification gas to efficiently adhere to the surface of the first crystalline layer.

Note that the surface state of the first crystalline layer at this time differs depending on the substrate temperature as well as the mixing conditions of the surface modification gas and an acidic solution mist described later. Specifically, the surface of the first crystalline layer will either disappear during the formation of the second crystalline layer described below, or remains as an intermediate layer on the first crystalline layer. For example, to form an intermediate layer on α-Ga₂O₃ formed as the first crystalline layer, a gas mixture of ozone or oxygen mixed with a hydrochloric acid mist is suitably used as the surface modification gas.

The duration time of the surface modification process is appropriately determined based on the type of the first crystalline layer, the type of the second crystalline layer, or the conditions of the gas and the acidic mist used for the surface modification. Although the duration time is not limited to a particular value, it can be set to several tens of minutes to several days, for example, from a productivity perspective.

Although the above description illustrates an example in which the surface of the growing film is modified using the foregoing gas alone, the present invention is not limited thereto. For example, instead of the surface modification gas, the second gas mixture 432 may be used. Alternatively, a gas mixture of a second supporting agent mist, which has been atomized with an atomizer (not illustrated), and the surface modification gas may be supplied to the crystalline substrate 404.

As the second supporting agent mist, it is possible to use hydrochloric acid, hydrobromic acid, hydroiodic acid, sulfuric acid, nitric acid, hydrofluoric acid, an ammonium fluoride aqueous solution, a hydrogen peroxide solution, carboxylic acid, or a mixture thereof. However, from the perspective of production costs and process stability, hydrochloric acid is more preferably used.

The type of the solvent for such acidic solutions is not limited to a particular type. It may be an inorganic solvent, such as water, an organic solvent, such as alcohol, or a mixed solvent of inorganic and organic solvents. In the present invention, the solvent is preferably water. The acid concentration at this time is appropriately determined according to the film deposition conditions, but can be typically set to 0.01 mol/L to 2 mol/L.

The supply of the surface modification gas and the supporting agent mist may be performed under the same conditions throughout this step, or the type of the gas, the type of the solution, or their mixing ratio may be changed during the process.

After a predetermined processing time has elapsed, the valve 411c is closed to stop the supply of the surface modification gas.

### [Step of forming second crystalline layer]

Next, the second crystalline layer is formed.

The valve 411a is opened to mix a carrier gas sent from the carrier gas source 401a with a raw material mist in the atomizer 402a, thereby forming a first gas mixture 431. Then, the first gas mixture 431 is supplied into the film deposition chamber 406. The conditions of a raw material solution 421 used herein may be the same as the conditions for forming the first crystalline layer, or may differ within the range of the conditions of applicable raw material solutions described above. However, it is necessary to attain the same composition as that of the first crystalline layer.

The composition and the flow rate of the carrier gas may be either the same as or different from those for forming the first crystalline layer. That is, for example, air, oxygen, or ozone, as well as an inert gas, such as nitrogen or argon, or a reducing gas, such as a hydrogen gas or a forming gas, is suitably used. One type of carrier gas may be used, or two or more types of carrier gas may be used. The flow rate of the carrier gas varies depending on the substrate size and the size of the film deposition chamber, but can be set to about 0.01 to 40 L/min.

The raw material of impurities used for doping to impart conductivity to at least a part of the second crystalline layer is not limited to a particular material. For example, when the foregoing raw material solution contains at least gallium, the impurities may be n-type dopants, such as silicon, germanium, tin, magnesium, titanium, zirconium, vanadium, or niobium; or p-type dopants, such as iron, copper, silver, cobalt, iridium, rhodium, magnesium, or nickel. Such compounds are preferably mixed into the raw material solution in an amount of 0.0001 to 0.1 atomic percent, and more preferably, 0.0001 to 0.01 atomic percent.

In addition, a valve 411b is opened to mix a carrier gas sent from the carrier gas source 401b with a supporting agent mist in the atomizer 402b, thereby forming a second gas mixture 432. Then, the second gas mixture 432 can be supplied into the film deposition chamber 406.

The second gas mixture 432 may be a gas mixture containing a supporting agent mist obtained by turning an acidic solution 422 into a mist. That is, the second gas mixture 432 may be a gas mixture formed by mixing a mist, which has been obtained by atomizing the acidic solution 422, with the carrier gas. As the acidic solution 422, it is possible to use hydrochloric acid, hydrobromic acid, hydroiodic acid, sulfuric acid, nitric acid, carboxylic acid, or a mixture thereof. However, from the perspective of production costs and process stability, hydrochloric acid is more preferably used.

The type of the solvent for the acidic solution 422 is not limited to a particular type. It may be an inorganic solvent, such as water, an organic solvent, such as alcohol, or a mixed solvent of inorganic and organic solvents. In the present invention, the solvent is preferably water. The acid concentration at this time is appropriately determined according to the film deposition conditions, but can be typically set to 0.01 mol/L to 2 mol/L.

The type of the carrier gas mixed with the second gas mixture 432 is not limited to a particular type. For example, air, oxygen, or ozone, as well as an inert gas, such as nitrogen or argon, or a reducing gas, such as a hydrogen gas or a forming gas, is suitably used. The carrier gas used herein may be either the same as or different from the carrier gas mixed with the first gas mixture 431. In addition, the flow rate of the second gas mixture 432 may be appropriately adjusted according to the desired film and its film deposition conditions, but it is typically preferably set to 2 to 50 times (in terms of the molar ratio) that of the metal element in the first gas mixture.

Such a supporting agent has the effect of suppressing the generation and growth (i.e., abnormal growth) of crystals of crystalline phases different from the desired crystals on the surface of the growing film, or stabilizing the growth of crystals of the desired crystalline phase. This allows for the stable formation of a high-quality second crystalline layer.

In addition, the supply of such a supporting agent mist to the crystalline substrate 404 is preferably performed both in the step of forming the first crystalline layer and the step of forming the second crystalline layer. This allows for the manufacture of a laminate including first and second crystalline layers with even higher quality.

Each of the first gas mixture 431 and the second gas mixture 432 introduced into the film deposition chamber 406 reacts with the crystalline substrate 404 heated in the film deposition chamber 406 by the heat source 407, thereby forming the second crystalline layer on the first crystalline layer.

The temperature of the crystalline substrate 404 is appropriately optimized based on the raw materials used and the desired product to be formed. For example, to form a metastable crystalline phase of gallium oxide as the second crystalline layer, the temperature of the crystalline substrate 404 is typically preferably set to 300°C to 600°C. At temperatures of 300°C or higher, the crystalline region is expected to be larger than the amorphous region, and at temperatures equal to or below 600°C, the metastable phase can be maintained more stably.

At this time, the second crystalline layer has a different crystalline phase from the first crystalline layer. This is considered to be because nucleation of the second crystalline layer has been promoted by interactions between molecules adhering to the surface of the first crystalline layer due to the foregoing surface modification process and molecules derived from the mist contained in the gas mixture. In contrast, the intermediate layer is considered to be in a state where at least a part of it is bonded to the surface of the first crystalline layer due to the surface modification process.

The film deposition chamber 406 for forming the second crystalline layer may be either the same as or different from that used for forming the first crystalline layer. In the latter case, the shape and the material of the film deposition chamber 406 are not limited to particular ones. For example, metals, such as aluminum and stainless steel, may be used. Alternatively, quartz or silicon carbide may be used if film deposition is performed at higher temperatures exceeding the heatproof temperature of such metals.

Film deposition may be performed under any of the following conditions: under atmospheric pressure, under pressure, and under reduced pressure. However, from the perspective of apparatus costs and productivity, film deposition is preferably performed under atmospheric pressure. Note that the film thickness can be appropriately set by adjusting the film deposition time.

After a predetermined time has elapsed from the start of supply of the first gas mixture 431, the supply of the raw material mist is stopped to halt the film deposition. The method for stopping the supply of the raw material mist is not limited to a particular method. For example, the supply of the raw material mist may be stopped simply by stopping the atomization of the raw material, by closing the valves 411a and 411b while continuing the atomization of the raw material to stop the supply of the carrier gas from the carrier gas sources 401a and 401b, or by performing both stopping the atomization of the raw material and closing the valves 411a and 411b.

According to such a method for manufacturing a laminate, it is possible to easily, inexpensively, and stably manufacture a high-performance laminate suitable for semiconductor devices.

### EXAMPLES

Hereinafter, the present invention will be described in detail by way of Examples, but these are not intended to limit the scope of the present invention.

### (Example 1)

### [Step of heating crystalline substrate and step of forming first gas mixture]

A laminate according to the present invention was manufactured using a mist CVD apparatus similar to that illustrated in FIG. 4.

Two atomizers made of quartz (i.e., the atomizer 402a and the atomizer 402b) and a film deposition chamber made of quartz were provided. In addition, compressed dry air was used as a surface modification gas. A compressed dry air supply source and the atomizers 402a and 402b were connected to the film deposition chamber via quartz pipes.

Next, hydrochloric acid was added to a 0.05 mol/L aqueous solution of gallium acetylacetonate at a rate of 0.2 mol/L. Then, the mixture was agitated with a stirrer for 60 minutes to obtain a raw material solution. The atomizer 402a was filled with such a precursor. In addition, hydrochloric acid was mixed with pure water so as to achieve a concentration of 0.6 mol/L, and the atomizer 402b was filled with the obtained mixture.

Next, a c-plane sapphire substrate with a diameter of 10 cm and a thickness of 0.65 mm was placed on a susceptor disposed in the film deposition chamber, and was then heated to achieve a substrate temperature of 450°C.

Next, ultrasonic vibrations were transmitted to the precursors in the atomizers 402a and 402b through water, using a 2.4 MHz ultrasonic transducer, so that the precursors were atomized (i.e., turned into mists). Then, a nitrogen gas was added into the atomizer 402a at a flow rate of 5 L/min to form a gas mixture (i.e., a first gas mixture) of the atomized raw material solution and the nitrogen gas.

### [Step of forming first crystalline layer]

The obtained first gas mixture was supplied into the film deposition chamber. In addition, dry air was added into the atomizer 402b at a flow rate of 5 L/min, so that the resulting gas mixture of the atomized hydrochloric acid (i.e., the supporting agent mist) and the dry air was supplied concurrently with the first gas mixture. After the supply of the gas mixture for 20 minutes, atomization of the atomizers 402a and 402b was stopped, and all gas supplies were stopped.

### [Step of modifying surface]

Next, the substrate was taken out of the film deposition chamber, and was cooled to near room temperature. Then, the substrate was transferred to a thermostatic bath. The interior of the thermostatic bath was replaced with dry air, and was maintained at 30°C for 30 minutes.

### [Step of forming second crystalline layer]

After that, the substrate was taken out of the thermostatic bath, and was placed back on the susceptor disposed in the film deposition chamber. The substrate was then heated to achieve a substrate temperature of 450°C.

Next, ultrasonic vibrations were transmitted to the precursors in the atomizers 402a and 402b through water, using a 2.4 MHz ultrasonic transducer, so that the raw material solutions were atomized.

Next, a nitrogen gas was added into the atomizer 402a at a flow rate of 10 L/min. The resulting gas mixture (i.e., the first gas mixture) of the atomized raw material solution and the nitrogen gas was supplied into the film deposition chamber. In addition, dry air was added into the atomizer 402b at a flow rate of 5 L/min, so that the resulting gas mixture of the atomized hydrochloric acid (i.e., the supporting agent mist) and the dry air was supplied concurrently with the first gas mixture. After the supply of the gas mixture for 60 minutes, atomization of the atomizers 402a and 402b was stopped, and all gas supplies were stopped.

The heating of the substrate was stopped. Then, the substrate was cooled to near room temperature, and was then taken out of the film deposition chamber.

### [Evaluation]

The thus formed laminate exhibited peaks at around 2θ = 38.9° and 40.3° in a 20/ω X-ray diffraction scan using CuKα radiation, and thus was confirmed to contain ε-Ga₂O₃ and α-Ga₂O₃. Further, EBSD analysis of the cross-section revealed that α-Ga₂O₃ was formed on the substrate, and ε-Ga₂O₃ was further formed thereon. Cross-sectional observation of the laminate revealed that the α-Ga₂O₃ layer has a thickness of about 200 nm, and the ε-Ga₂O₃ layer has a thickness of about 1200 nm.

Next, the dislocation density of each of the stacked films was evaluated. The dislocation density was quantified by using a sample prepared by thinning a longitudinal cross-section of the laminate to a thickness of 100 nm, and using TEM.

### (Example 2)

Film deposition was performed as in Example 1, except that the supporting agent mist formed in the atomizer 402b was not used (i.e., a gas mixture of a hydrochloric acid mist and dry air was not supplied) in the step of forming the second crystalline layer.

The thus formed laminate exhibited peaks at around 2θ = 38.9° and 40.3° in an X-ray diffraction measurement, and thus was confirmed to contain ε-Ga₂O₃ and α-Ga₂O₃. Further, EBSD analysis of the cross-section revealed that α-Ga₂O₃ was formed on the substrate, and ε-Ga₂O₃ was further formed thereon. Cross-sectional observation of the laminate revealed that the α-Ga₂O₃ layer has a thickness of about 200 nm, and the ε-Ga₂O₃ layer has a thickness of about 1200 nm.

Next, the dislocation density of each of the first and second crystalline layers was evaluated as in Example 1.

### (Example 3)

Film deposition was performed as in Example 1, except that the supporting agent mist formed in the atomizer 402b was not used (i.e., a gas mixture of a hydrochloric acid mist and dry air was not supplied) in the step of forming the first crystalline layer.

The thus formed laminate exhibited peaks at around 2θ = 38.9° and 40.3° in an X-ray diffraction measurement, and thus was confirmed to contain ε-Ga₂O₃ and α-Ga₂O₃. Further, EBSD analysis of the cross-section revealed that α-Ga₂O₃ was formed on the substrate, and ε-Ga₂O₃ was further formed thereon. Cross-sectional observation of the laminate revealed that the α-Ga₂O₃ layer has a thickness of about 200 nm, and the ε-Ga₂O₃ layer has a thickness of about 1200 nm.

Next, the dislocation density of each of the first and second crystalline layers was evaluated as in Example 1.

### (Example 4)

Film deposition was performed as in Example 1, except that the supporting agent mist formed in the atomizer 402b was not used (i.e., a gas mixture of a hydrochloric acid mist and dry air was not supplied) in each of the step of forming the first crystalline layer and the step of forming the second crystalline layer.

The thus formed laminate exhibited peaks at around 2θ = 38.9° and 40.3° in an X-ray diffraction measurement, and thus was confirmed to contain ε-Ga₂O₃ and α-Ga₂O₃. Further, EBSD analysis of the cross-section revealed that α-Ga₂O₃ was formed on the substrate, and ε-Ga₂O₃ was further formed thereon. Cross-sectional observation of the laminate revealed that the α-Ga₂O₃ layer has a thickness of about 200 nm, and the ε-Ga₂O₃ layer has a thickness of about 1200 nm.

Next, the dislocation density of each of the first and second crystalline layers was evaluated as in Example 1.

### (Example 5)

After the first crystalline layer was formed as in Example 1, the substrate was held at 450°C in the film deposition chamber.

Next, surface modification was performed by supplying a gas mixture, which had been obtained by adding a mixed gas of nitrogen and ozone (10 vol% ozone) at a flow rate of 5 L/min to hydrochloric acid (0.6 mol/L) atomized in the atomizer 402b, to the substrate for 30 minutes.

After that, the second crystalline layer was formed as in Example 1.

The thus formed laminate exhibited peaks at around 2θ = 38.9° and 40.3° in an X-ray diffraction measurement, and thus was confirmed to contain ε-Ga₂O₃ and α-Ga₂O₃. Further, EBSD analysis of the cross-section revealed that α-Ga₂O₃ was formed on the substrate, and ε-Ga₂O₃ was further formed thereon. Cross-sectional observation of the laminate revealed that the α-Ga₂O₃ layer has a thickness of about 200 nm, and the ε-Ga₂O₃ layer has a thickness of about 1200 nm, and further, an oxygen-rich intermediate layer with a thickness of 1 to 2 nm was observed between such layers.

Next, the dislocation density of each of the first and second crystalline layers was evaluated as in Example 1.

### (Comparative example)

Film deposition was performed as in Example 1, except that the surface modification process was not performed after the formation of the first crystalline layer.

The thus formed laminate exhibited a peak at around 2θ = 40.3° in an X-ray diffraction measurement, and thus was confirmed to contain α-Ga₂O₃.

### (Example 6)

As the raw material solution used in the step of forming the first crystalline layer (i.e., the electron injection layer), a solution, which had been obtained by adding hydrochloric acid to a 0.05 mol/L aqueous solution of gallium acetylacetonate at a rate of 0.2 mol/L, and then agitating the mixture with a stirrer for 60 minutes, and further mixing tin(II) chloride dihydrate into the resulting solution so as to achieve a Sn/Ga ratio of 0.1%, was used. In addition, as the raw material solution used in the step of forming the second crystalline layer (i.e., the electron transport layer), a solution, which had been obtained by adding hydrochloric acid to a 0.1 mol/L aqueous solution of gallium acetylacetonate at a rate of 0.25 mol/L, and then agitating the mixture with a stirrer for 60 minutes, and further mixing tin(II) chloride dihydrate into the resulting solution so as to achieve a Sn/Ga ratio of 0.001%, was used. Regarding the other conditions, film deposition was performed as in Example 1.

The thus manufactured laminate exhibited peaks at around 2θ = 38.9° and 40.3° in a 2θ/ω X-ray diffraction scan using CuKα radiation, and thus was confirmed to contain ε-Ga₂O₃ and α-Ga₂O₃. Further, EBSD analysis of the cross-section revealed that α-Ga₂O₃ was formed on the substrate, and ε-Ga₂O₃ was further formed thereon. Cross-sectional observation of the laminate revealed that the α-Ga₂O₃ layer has a thickness of about 200 nm, and the ε-Ga₂O₃ layer has a thickness of about 1200 nm.

Next, the resistivity of each layer was evaluated using the spreading resistance method. Then, the first crystalline layer was found to have a resistivity of 0.2 Ω·cm, and the second crystalline layer was found to have a resistivity of 14.2 Ω·cm. In addition, the dislocation density of each of the first and second crystalline layers was evaluated as in Example 1.

Table 1 illustrates the results of Examples 1 to 6 and Comparative Example.

As shown in Table 1, with the film deposition method of the present invention, laminates each including the same composition but different crystalline phases were obtained. In addition, laminates useful for electronic devices were obtained.

In contrast, with the film deposition of the conventional method (i.e., Comparative Example), no crystalline phase transition occurred, and only a film of one crystalline layer was formed.

**[Table 1]**

| | Crystalline Form | | Dislocation Density [cm⁻²] | |
|---|---|---|---|---|
| | First Crystalline Layer | Second Crystalline Layer | First Crystalline Layer | Second Crystalline Layer |
| Example 1 | α | ε | 2.3 × 10¹⁰ | 8.5 × 10⁹ |
| Example 2 | α | ε | 2.5 × 10¹⁰ | 1.2 × 10¹⁰ |
| Example 3 | α | ε | 7.8 × 10¹⁰ | 9.2 × 10⁹ |
| Example 4 | α | ε | 7.5 × 10¹⁰ | 2.9 × 10¹⁰ |
| Example 5 | α | ε | 2.3 × 10¹⁰ | 7.0 × 10⁸ |
| Comparative Example | α | α | - | - |
| Example 6 | α | ε | 2.6 × 10¹⁰ | 8.1 × 10⁹ |

From the results, it was found that according to the method for manufacturing a laminate containing a crystalline metal oxide semiconductor of the present invention, a high-quality laminate, which has not been obtained with the conventional technology, can be manufactured using an easy, inexpensive, low-temperature process.

The present description includes the following embodiments.
[1]: A laminate comprising:
   a crystalline substrate;
   a first crystalline layer formed on a main surface of the crystalline substrate either directly or with another layer interposed therebetween, the first crystalline layer being composed primarily of a first crystalline metal oxide semiconductor; and
   a second crystalline layer formed on the first crystalline layer either directly or with another layer interposed therebetween, the second crystalline layer being composed primarily of a second crystalline metal oxide semiconductor, wherein
   the second crystalline metal oxide semiconductor has the same composition as the first crystalline metal oxide semiconductor, and has a different crystalline phase from the first crystalline metal oxide semiconductor.
[2]: The laminate according to the above [1], wherein each of the first crystalline metal oxide semiconductor and the second crystalline metal oxide semiconductor is gallium oxide.
[3]: The laminate according to the above [1] or [2], wherein the first crystalline metal oxide semiconductor is α-gallium oxide.
[4]: The laminate according to any of the above [1] to [3], wherein the second crystalline metal oxide semiconductor is ε-gallium oxide or κ-gallium oxide.
[5]: The laminate according to any of the above [1] to [4], wherein electric resistivity of the first crystalline layer is 5 Ωcm or less.
[6]: The laminate according to any of the above [1] to [5], wherein the second crystalline layer has higher electric resistivity than the first crystalline layer.
[7]: The laminate according to any of the above [1] to [6], comprising an intermediate layer as the other layer provided between the first crystalline layer and the second crystalline layer.
[8]: The laminate according to any of the above [1] to [7], wherein the crystalline substrate is a sapphire substrate.
[9]: A semiconductor device comprising at least a semiconductor layer and an electrode, wherein the semiconductor layer includes the first crystalline layer and the second crystalline layer of the laminate according to any of the above [1] to [8].
[10]: A method for manufacturing a laminate containing a crystalline metal oxide semiconductor, comprising the steps of:
   heating a crystalline substrate;
   forming a first gas mixture by mixing a raw material solution mist containing an atomized metal oxide precursor with a carrier gas;
   forming a first crystalline layer by supplying the first gas mixture to the crystalline substrate, the first crystalline layer being composed primarily of a first crystalline metal oxide semiconductor;
   modifying a surface of the first crystalline layer by exposing the surface to a surface modification atmosphere; and
   forming a second crystalline layer by supplying the first gas mixture to the crystalline substrate having the first crystalline layer with the modified surface, the second crystalline layer being composed primarily of a second crystalline metal oxide semiconductor having the same composition as the first crystalline metal oxide semiconductor and having a different crystalline phase from the first crystalline metal oxide semiconductor.
[11]: The method for manufacturing a laminate according to the above [10], wherein each of the first crystalline metal oxide semiconductor and the second crystalline metal oxide semiconductor is gallium oxide.
[12]: The method for manufacturing a laminate according to the above [10] or [11], wherein the surface modification atmosphere is an atmosphere containing one of nitrogen, carbon dioxide, oxygen, ozone, and water vapor.
[13]: The method for manufacturing a laminate according to any of the above [10] to [12], wherein a substrate temperature in the step of modifying the surface of the first crystalline layer is set lower than or equal to a substrate temperature in the step of forming the first crystalline layer.
[14]: The method for manufacturing a laminate according to any of the above [10] to [13], wherein the substrate temperature in the step of modifying the surface of the first crystalline layer is set to 20°C or higher and 500°C or lower.
[15]: The method for manufacturing a laminate according to any of the above [10] to [14], wherein the step of forming the first crystalline layer includes further supplying a second gas mixture to the crystalline substrate, the second gas mixture being formed by mixing a supporting agent mist containing an atomized acidic solution with a carrier gas.
[16]: The method for manufacturing a laminate according to any of the above [10] to [15], wherein the step of forming the second crystalline layer includes further supplying a second gas mixture to the crystalline substrate, the second gas mixture being formed by mixing a supporting agent mist containing an atomized acidic solution with a carrier gas.
[17]: The method for manufacturing a laminate according to any of the above [10] to [16], wherein each of the step of forming the first crystalline layer and the step of forming the second crystalline layer includes further supplying a second gas mixture to the crystalline substrate, the second gas mixture being formed by mixing a supporting agent mist containing an atomized acidic solution with a carrier gas.
[18]: The method for manufacturing a laminate according to any of the above [15] to [17], wherein the acidic solution contains hydrochloric acid.

Note that the present invention is not limited to the foregoing embodiments. The foregoing embodiments are only examples, and thus, any example that substantially has the same features as and achieves similar operational advantages to those of the technical concept disclosed in the claims of the present invention falls within the technical scope of the present invention.

## Claims

1. A laminate comprising:
a crystalline substrate;
a first crystalline layer formed on a main surface of the crystalline substrate either directly or with another layer interposed therebetween, the first crystalline layer being composed primarily of a first crystalline metal oxide semiconductor; and
a second crystalline layer formed on the first crystalline layer either directly or with another layer interposed therebetween, the second crystalline layer being composed primarily of a second crystalline metal oxide semiconductor, wherein
the second crystalline metal oxide semiconductor has the same composition as the first crystalline metal oxide semiconductor, and has a different crystalline phase from the first crystalline metal oxide semiconductor.

2. The laminate according to claim 1, wherein each of the first crystalline metal oxide semiconductor and the second crystalline metal oxide semiconductor is gallium oxide.

3. The laminate according to claim 1, wherein the first crystalline metal oxide semiconductor is α-gallium oxide.

4. The laminate according to claim 1, wherein the second crystalline metal oxide semiconductor is ε-gallium oxide or x-gallium oxide.

5. The laminate according to claim 1, wherein electric resistivity of the first crystalline layer is 5 Ωcm or less.

6. The laminate according to claim 1, wherein the second crystalline layer has higher electric resistivity than the first crystalline layer.

7. The laminate according to claim 1, comprising an intermediate layer as the other layer provided between the first crystalline layer and the second crystalline layer.

8. The laminate according to claim 1, wherein the crystalline substrate is a sapphire substrate.

9. A semiconductor device comprising at least a semiconductor layer and an electrode, wherein the semiconductor layer includes the first crystalline layer and the second crystalline layer of the laminate according to any one of claims 1 to 8.

10. A method for manufacturing a laminate containing a crystalline metal oxide semiconductor, comprising the steps of:
heating a crystalline substrate;
forming a first gas mixture by mixing a raw material solution mist containing an atomized metal oxide precursor with a carrier gas;
forming a first crystalline layer by supplying the first gas mixture to the crystalline substrate, the first crystalline layer being composed primarily of a first crystalline metal oxide semiconductor;
modifying a surface of the first crystalline layer by exposing the surface to a surface modification atmosphere; and
forming a second crystalline layer by supplying the first gas mixture to the crystalline substrate having the first crystalline layer with the modified surface, the second crystalline layer being composed primarily of a second crystalline metal oxide semiconductor having the same composition as the first crystalline metal oxide semiconductor and having a different crystalline phase from the first crystalline metal oxide semiconductor.

11. The method for manufacturing a laminate according to claim 10, wherein each of the first crystalline metal oxide semiconductor and the second crystalline metal oxide semiconductor is gallium oxide.

12. The method for manufacturing a laminate according to claim 10, wherein the surface modification atmosphere is an atmosphere containing one of nitrogen, carbon dioxide, oxygen, ozone, and water vapor.

13. The method for manufacturing a laminate according to claim 10, wherein a substrate temperature in the step of modifying the surface of the first crystalline layer is set lower than or equal to a substrate temperature in the step of forming the first crystalline layer.

14. The method for manufacturing a laminate according to claim 13, wherein the substrate temperature in the step of modifying the surface of the first crystalline layer is set to 20°C or higher and 500°C or lower.

15. The method for manufacturing a laminate according to claim 10, wherein the step of forming the first crystalline layer includes further supplying a second gas mixture to the crystalline substrate, the second gas mixture being formed by mixing a supporting agent mist containing an atomized acidic solution with a carrier gas.

16. The method for manufacturing a laminate according to claim 10, wherein the step of forming the second crystalline layer includes further supplying a second gas mixture to the crystalline substrate, the second gas mixture being formed by mixing a supporting agent mist containing an atomized acidic solution with a carrier gas.

17. The method for manufacturing a laminate according to claim 10, wherein each of the step of forming the first crystalline layer and the step of forming the second crystalline layer includes further supplying a second gas mixture to the crystalline substrate, the second gas mixture being formed by mixing a supporting agent mist containing an atomized acidic solution with a carrier gas.

18. The method for manufacturing a laminate according to any one of claims 15, 16, and 17, wherein the acidic solution contains hydrochloric acid.
